# EUROPEAN PATENT SPECIFICATION

(11) **EP 2 776 850 B1**
(45) Date of publication and mention of the grant of the patent: **18.05.2016**
(21) Application number: 12798496.1
(22) Date of filing: 09.11.2012
(51) Int. Cl.: G01P 15/08, G01P 15/125, B81B 3/00

(54) **PROOF MASS POSITIONING FEATURES HAVING CURVED CONTACT SURFACES**
PRÜFMASSENPOSITIONIEREINICHTUNGEN MIT GEKRÜMMTEN KONTAKTFLÄCHEN
ELÉMENTS DE POSITIONNEMENT DE MASSE D'ESSAI AYANT DES SURFACES DE CONTACT TANGENTIELLES

(30) Priority: 09.11.2011 US 201161557767 P
(43) Date of publication of application: 17.09.2014
(73) Proprietor: Robert Bosch GmbH, 70442 Stuttgart (DE); O'Brien, Gary, Palo Alto, CA 94304 (US)
(72) Inventor: O'BRIEN, Gary, Palo Alto, CA 94304 (US)
(74) Representative: Isarpatent
(86) International application number: PCT/US2012/064464
(87) International publication number: WO 2013/071118

(56) References cited:
- EP-A1- 1 750 132
- US-A- 5 914 521
- US-A1- 2010 186 508
- US-A1- 2011 147 860

## Description

The present invention relates to a micro electromechanical system.
EP 1 750 132 A1 discloses a micro electromechanical system including a substrate, a proof mass with a first curved surface on a first side of the proof mass at a position above a surface of substrate, and a first travel stop fixed in this respect to the substrate and including a second curved surface generally opposite to the first curved surface along a first axis, wherein the proof mass is movable along a first axis in a direction toward the first travel stop.
Similar micro electromechanical systems are known from US 2011/0147860 A1 and US 5,914,521. US 2010/0186508 A1 discloses a sensor device and method for manufacturing a sensor device, which sensor device includes a seismic mass having at least one resilient area that includes at least one stop and at least one displaceable remaining area, and the resilient area being connected to the remaining area via at least one spring.

### BACKGROUND

Micro-electromechanical systems referred to herein as "MEMS" or "MEMS devices", integrate electrical and mechanical components on the same silicon substrate using microfabrication technologies. The electrical components are fabricated using integrated circuit processes, while the mechanical components are fabricated using micromachining processes compatible with the integrated circuit processes. This combination makes it possible to fabricate an entire electromechanical system on a silicon substrate using standard manufacturing processes.

A common application of MEMS devices is the design and manufacture of sensors. These sensors have proven to be effective solutions in various applications due to the sensitivity, spatial and temporal resolutions, and lower power requirements exhibited by MEMS devices. Consequently, MEMS sensors, such as inertial sensors, gyroscopes and pressure sensors, have been developed for use in a wide variety of applications.

MEMS inertial sensors are useful for measuring both static and dynamic acceleration. In particular, MEMS inertial sensors may be used to sense the orientation and position of a device. One type of MEMS inertial sensor includes a proof mass supported above a substrate anchor by a spring. The substrate anchor defines a cavity in which the proof mass is movably positioned. The spring positions the proof mass in a neutral position within the cavity. When the substrate anchor accelerates, the proof mass moves from the neutral position relative the substrate anchor, but remains within the cavity. The spring constant of the spring, among other factors, determines the amount of movement exhibited by the proof mass in response to acceleration of the substrate anchor. The travel span of the proof mass within the cavity is referred to as a displacement range. Electrical leads may be connected to the substrate anchor and the proof mass. Acceleration of the substrate anchor can be sensed by measuring the capacitance between the substrate anchor and the proof mass.

Some known MEMS inertial sensors incorporate one or more positioning features to limit and to define the displacement range of the proof mass within the cavity. If the sensor is subjected to a force that exceeds a threshold force, the proof mass may move to a position of maximum displacement. The positioning features ensure the proof mass remains properly positioned within the cavity even after the proof mass has been moved to a position of maximum displacement. Furthermore, positioning features prevent the proof mass from moving to a position that breaks, fractures, or otherwise damages the spring.

In the past, positioning features were implemented with a flat surface on the substrate anchor and a corresponding flat surface on the proof mass. These flat surfaces contact each other when the proof mass is moved to a position of maximum displacement. Although positioning features having flat surfaces effectively limit and define the maximum displacement of the proof mass, stiction may occur as a result of contact between the flat surfaces.

The term "stiction", as used herein, refers to the force that must be overcome to move a first object that is in physical contact with a second object. In general, stiction increases in relation to the surface area of the contact region between the first and second objects. As applied to MEMS having positioning features with flat contact surfaces, stiction may occur as a result of large external physical shocks, such as drop tests, and spring-mass resonant frequency excitation, etc. As reported by G. J. O'Brian, D. J. Monk, and L. Lin, "A Stiction Study Via Capacitance-Voltage (C-V) Plot Electrostatic Actuation/Latching", American Society of Mechanical Engineering MEMS, Vol. 1, pp. 275-280 (1999), electrostatic self-test actuation of MEMS inertial sensors is also an event that may result in stiction.

Stiction may cause a MEMS inertial sensor to generate false measurements or become inoperable. In particular, some stiction causing events may cause the proof mass to adhere permanently to the substrate anchor, thereby resulting in the MEMS ceasing to sense acceleration. Other stiction causing events, however, may cause the proof mass to adhere temporarily to the substrate anchor, which may result in the MEMS inaccurately sensing acceleration. Therefore, both temporary and permanent adhesion of the proof mass to the substrate anchor as a result of stiction may cause a MEMS inertial sensor to generate false measurements.

Accordingly, a MEMS inertial sensor subject to less stiction between the substrate anchor and the proof mass would be beneficial.

### SUMMARY

A micro electromechanical system (MEMS) according to the present invention is defined in independent claim 1.

### BRIEF DESCRIPTION OF THE FIGURES

Features of the device and method disclosed herein will become apparent to those skilled in the art from the following description with reference to the figures, in which:
FIG. 1 depicts a perspective view of a micro electromechanical system ("MEMS") having proof mass positioning features that include concave followers on a proof mass and convex travel stops on an anchor;
FIG. 2 depicts a cross sectional view of the MEMS along line 2-2 of FIG. 1;
FIG. 3 depicts a top plan view of the MEMS of FIG. 1;
FIG. 4 depicts a partial top plan view of a positioning feature of the MEMS of FIG. 1, the proof mass being in a neutral position;
FIG. 5 depicts a partial top plan view of a positioning feature of the MEMS of FIG. 1, the proof mass being in a position of maximum negative displacement along the x-axis;
FIG. 6 depicts a partial top plan view of a positioning feature of the MEMS of FIG. 1, the proof mass being in a position of maximum negative displacement along the y-axis;
FIG. 7 depicts a top plan view of an embodiment of a MEMS having proof mass positioning features that include concave followers on a proof mass and convex travel stops on an anchor;
FIG. 8 depicts a top plan view of an example of a MEMS having proof mass positioning features that include concave followers on an anchor and convex travel stops on a proof mass which is not part of the invention;
FIG. 9 depicts a top plan view of an embodiment of a MEMS having proof mass positioning features that include rectangular followers on a proof mass and convex travel stops on an anchor;
FIG. 10 depicts a top plan view of a mask for forming a MEMS having proof mass positioning features that include a first element and a second element separated by a submicron gap;
FIG. 11 depicts a top plan view of a MEMS formed with the mask of FIG. 10;
FIG. 12 depicts a top plan view of a mask for forming a MEMS having proof mass positioning features that include a first element and a second element separated by a submicron gap;
FIG. 13 depicts a top plan view of a MEMS formed with the mask of FIG. 12;
FIG. 14 depicts a schematic view of a MEMS tunneling tip accelerometer; and
FIG. 15 depicts a partial top plan view of a mask for forming a first and second tip of the tunneling tip accelerometer of FIG. 14.

### DESCRIPTION

For the purpose of promoting an understanding of the principles of the device and method described herein, reference will now be made to the embodiments illustrated in the figures and described in the following written specification. It is understood that no limitation to the scope of the device and method is thereby intended. It is further understood that the device and method includes any alterations and modifications to the illustrated embodiments and includes further applications of the principles of the device and method as would normally occur to one skilled in the art to which this device and method pertains.

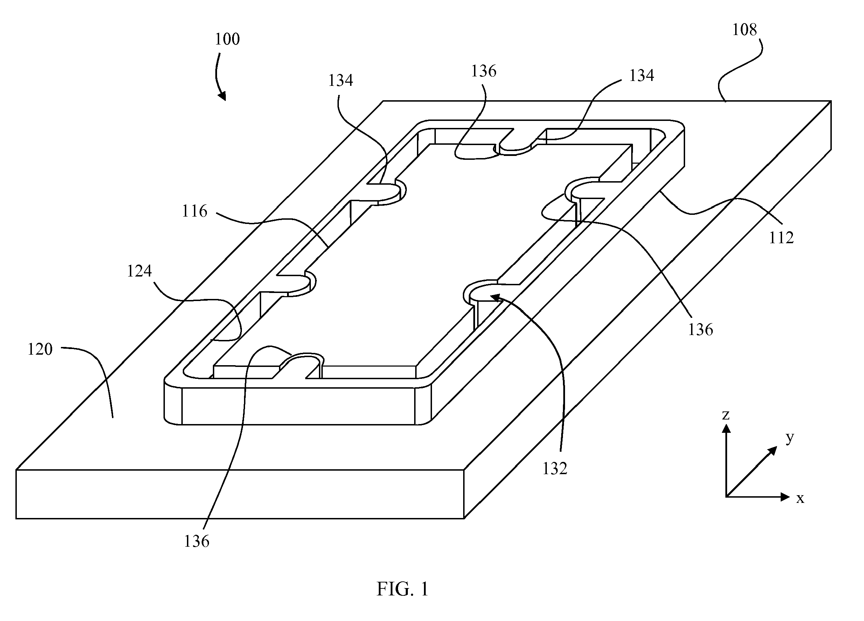

An exemplary embodiment of a micro electromechanical system ("MEMS") 100 is depicted in FIG. 1. The MEMS 100 is configured to sense acceleration. In particular, when the MEMS 100 accelerates in a direction having a component along the z-axis, the MEMS 100 generates an electrical output related to the acceleration.

The MEMS 100 includes a substrate 108, a wall 112, and a proof mass 116. The substrate 108 defines a surface 120 in an x-y plane that is generally normal, i.e. perpendicular, to the z-axis. The wall 112 is coupled to the substrate 108 and extends above the surface 120 along the z-axis. The wall 112 may be formed from the same material as the substrate 108, and, in some embodiments, may be integral with the substrate 108. Alternatively, the wall 112 may be a material different from the substrate 108 that is deposited on the surface 120 and bonded to the substrate 108. As illustrated in FIG. 1, the wall 112 is formed about the proof mass 116 as a unitary section of material; however, the wall 112 may also be formed about the proof mass 116 as sections of material separated by one or more spaces. The wall 112 and the surface 120 define a cavity 124. The cavity 124 has a length along the y-axis, a width along the x-axis, and a depth along the z-axis.

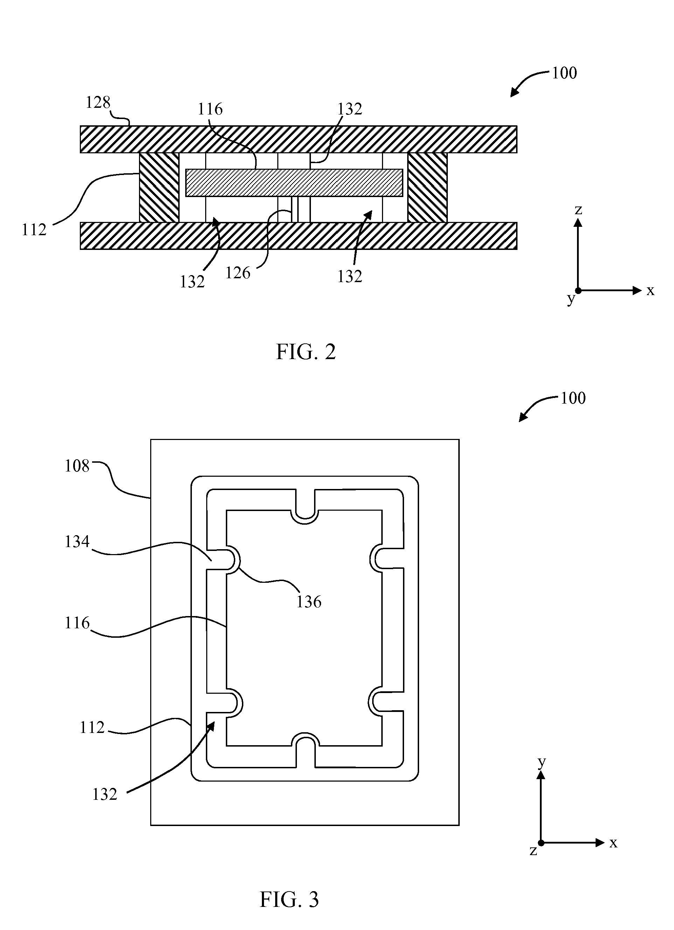

The proof mass 116 is positioned in the cavity 124 to move relative the substrate 108 in response to the MEMS 100 accelerating in a direction having a component along the z-axis. The proof mass 116 may be formed from a material different from the substrate 108. A spring 126 (FIG. 2) suspends the proof mass 116 above the substrate 108, as described below. The proof mass 116 has a length along the y-axis, a width along the x-axis, and a height along the z-axis. The length and width of the proof mass 116 are less than the length and width of the cavity 124 to permit the proof mass 116 to move within the cavity 124 along the x-axis, y-axis, and z-axis.

The MEMS 100 is described in further detail with reference to FIGS. 2 and 3. As shown in the cross-sectional view of FIG. 2, the MEMS 100 includes a spring 126 and a retaining element 128. The spring 126 suspends the proof mass 116 above the surface 120 in a neutral position. The proof mass 116 is illustrated in the neutral position in FIGS. 1-4. The spring constant of the spring 126 is related to the degree of displacement exhibited by the proof mass 116 in response to acceleration of the MEMS 100. In particular, a MEMS 100 having a spring 126 with a spring constant of a low magnitude may have a lower acceleration threshold than a MEMS 100 having a spring 126 with a spring constant of a greater magnitude. As used herein, the term "acceleration threshold" refers to a minimum acceleration the MEMS 100 is configured to sense. The spring 126 returns the proof mass 116 to the neutral position when the MEMS 100 ceases to accelerate and when the acceleration of the MEMS 100 falls below the acceleration threshold. The retaining element 128 (not illustrated in FIGS. 1 and 3) forms an upper boundary of the cavity 124 and is generally parallel to the surface 120. The retaining element 128 prevents the proof mass 116 from exiting the cavity 124 as a result of the MEMS 100 accelerating in a direction having a component along the minus z-axis direction.

The MEMS 100 includes positioning features 132 to limit the movement of the proof mass 116 relative the substrate 108 in directions along the x-axis and the y-axis. The positioning features 132 include a travel stop 134 and a follower 136. As shown in FIGS. 1 and 3, the follower 136 is formed on the proof mass 116 and the travel stop 134 is formed on the wall 112. However, in other embodiments, the follower 136 is formed on the wall 112 and the travel stop 136 contacts the travel stop 134 when the proof mass 116 moves to a position of maximum displacement along the x-axis and/or the y-axis.

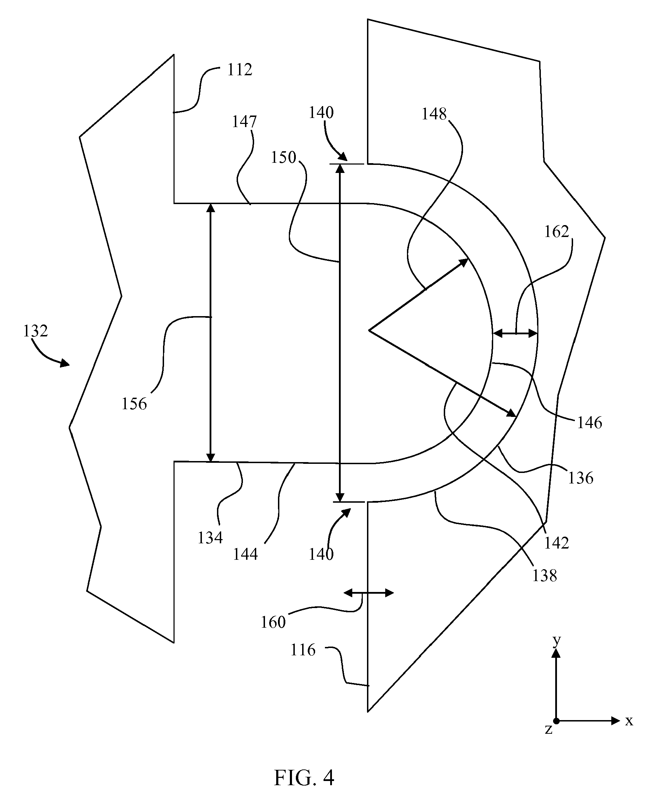

The positioning features 132 are described in further detail with reference to FIGS. 4-6. The followers 136 include a dimple 138 and a mouth 140. The dimple 138 defines a curved surface having a radius 142. The curved surface of the dimple 138 is positioned above the surface 120 of the substrate 108 and is a generally concave surface in the x-y plane. The mouth 140 defines the outer edge of the dimple 138. The mouth 140 has a length 150 that extends from a lower edge of the dimple 138 to an upper edge of the dimple 138. The travel stops 134 include a post 144 having a head 146 and a neck 147. The head 146 is connected to the end of the neck 147. The head 146 defines a curved surface that is a generally convex surface in the x-y plane. The curved surface of the head 146 has a radius 148. The radius 142 and the radius 148 are non-equal, and, in particular, the radius 142 is greater than the radius 148.

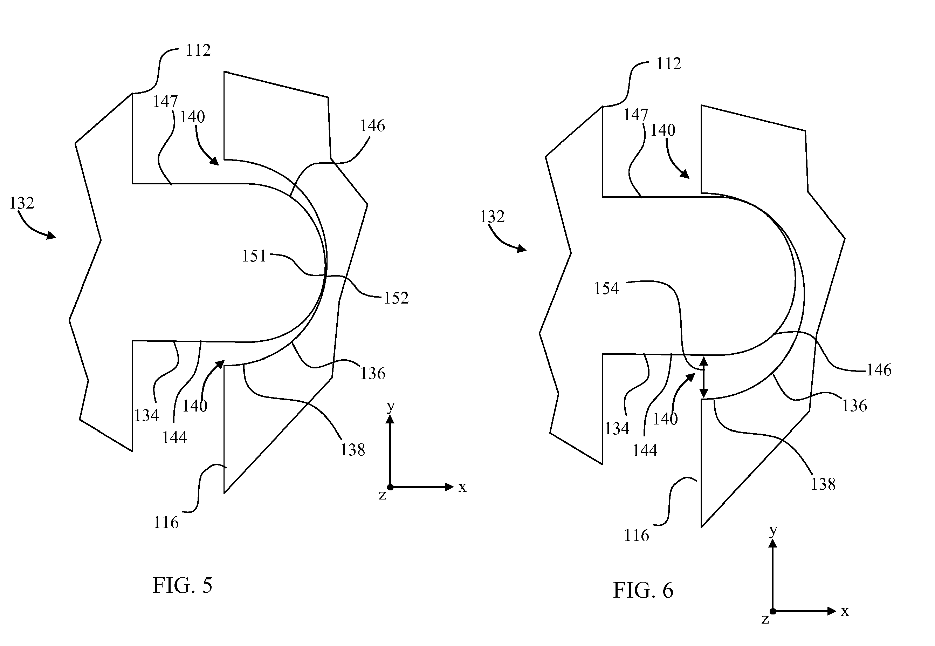

As shown in FIG. 4, when the proof mass 116 is in the neutral position, the travel stop 134 is positioned in the dimple 138. When the proof mass 116 is moved to a point of maximum displacement along the x-axis, apex 151 of the head 146 contacts apex 152 of the dimple 138, as shown in FIG. 5. As used herein, the term "apex" refers to the deepest point of the dimple 138 and the highest point of the head 146. Because the radius 142 is greater than the radius 148, contact between the apex 151 and the apex 152 is a point contact. When the proof mass 116 is moved to a point of maximum displacement along the y-axis, the neck 147 contacts the mouth 140 at a point contact, as shown in FIG. 6. When the proof mass 116 is moved to a position between a point of maximum displacement along the x-axis and a point of maximum displacement along the y-axis the head 146 contacts the dimple 138 at a point contact between the apex 152 and the mouth 140.

The positioning features 132 limit the motion of the proof mass 116 along the x-axis and the y-axis to fixed distances. Specifically, the positioning features 132 on the left and right sides of the MEMS 100 limit the motion of the proof mass 116 along the y-axis to a distance 154 (FIG. 6). In particular, the distance 154 is equal to the length 150 minus a thickness 156 of the neck 147. Furthermore, the positioning features 132 on the left and right sides of the MEMS 100 limit the motion of the proof mass 116 along the x-axis to a distance 160. Specifically, when the proof mass 116 is in the neutral position, a gap 162 separates the head 146 from the dimple 138. The distance 160 is equal to two times the length of the gap 162. The positioning features 132 on the upper and lower sides of the MEMS 100 limit the motion of the proof mass 116 along the x-axis to the distance 154 and limit the motion of the proof mass 116 along the y-axis to the distance 160.

The MEMS 100 may be formed with a reduced number of positioning features 132. Referring again to FIG. 3, the positioning features 132 on the left side of the MEMS 100 address over travel in the minus x-axis direction and the plus and minus y-axis directions, while the positioning features 132 on the right side of the MEMS 100 address over travel in the plus x-axis direction and the plus and minus y-axis directions. Accordingly, the MEMS 100 may address over travel of the proof mass 116 in each direction in the x-y plane with one positioning feature 132 on the left side of the MEMS 100 and one positioning feature 132 on the right side of the MEMS 100. Furthermore, the positioning feature 132 on the top side of the MEMS 100 addresses over travel in the plus and minus x-axis directions and the plus y-axis direction, while the positioning feature 132 on the bottom side of the MEMS 100 addresses over travel in the plus and minus x-axis directions and the minus y-axis direction. Therefore, the MEMS 100 may also address over travel of the proof mass 116 in each direction of the x-y plane with one positioning feature 132 on the top side of the MEMS 100 and one positioning feature 132 on the bottom side of the MEMS 100.

The positioning features 132 are configured to reduce stiction between the travel stop 134 and the follower 136 because a first curved surface having a radius smaller than a second curved surface necessarily contacts the second curved surface at a single point that is tangential to both curved surfaces. In particular, as shown in FIG. 5, the apex 151 of the head 146 contacts the apex 152 of the dimple 138 when the proof mass 116 has been moved to a position of maximum negative displacement along the x-axis. Similarly, as shown in FIG. 6, the head 146 contacts the mouth 140 when the proof mass 116 has been moved to a position of maximum positive displacement along the y-axis. In order to satisfy the tangent point contact region the radius 142 and the radius 148 are non-equal. The reduced surface area of the contact region reduces stiction between the follower 136 and the travel stop 134 as compared to known flat travel stops. Accordingly, the MEMS 100 has a reduced stiction threshold and, therefore, may be configured to measure a very small acceleration.

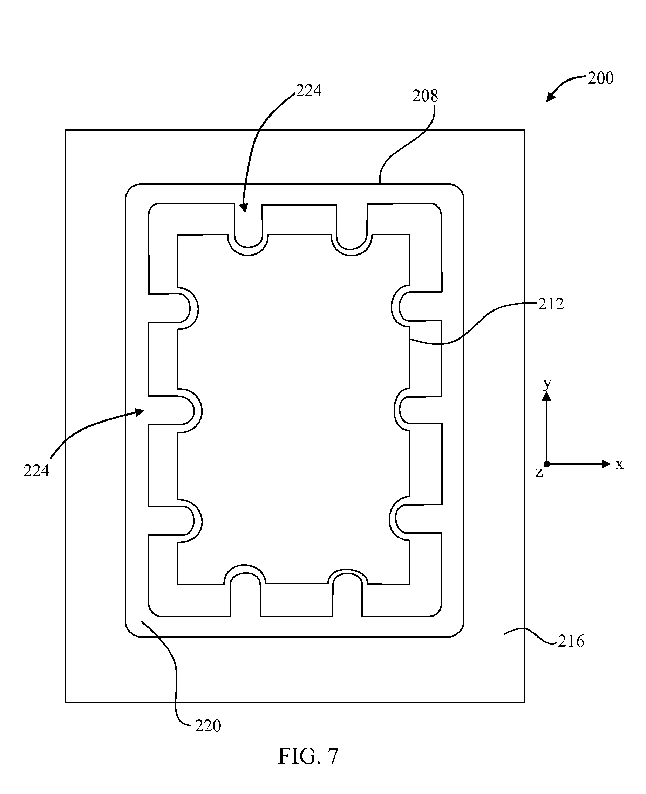

Referring now to FIG. 7, another embodiment of a MEMS 200 is illustrated. The MEMS 200 includes a substrate 204, a wall 208, and a proof mass 212. The substrate 204 defines a surface 216 in the x-y plane that is generally normal, i.e. perpendicular, to the z-axis. The wall 208 is coupled to the substrate 204 and extends above the surface 216 along the z-axis. The wall 208 and the surface 216 define a cavity 220 having a length along the y-axis, a width along the x-axis, and a depth along the z-axis. The proof mass 212 is positioned in the cavity 220 to move relative the substrate 204 in response to the MEMS 200 accelerating in a direction having a component along the z-axis.

The MEMS 200 includes positioning features 224 to limit the movement of the proof mass 212 relative the substrate 204 in directions along the x-axis and the y-axis. In particular, the MEMS 200 includes four additional positioning features 224 as compared to the MEMS 100. The additional positioning features 224 reduce the force exerted upon any one positioning feature 224 during periods of external physical shock, such as, but not limited to, drop tests, electrostatic self-test actuation, and spring-mass resonant frequency excitation.

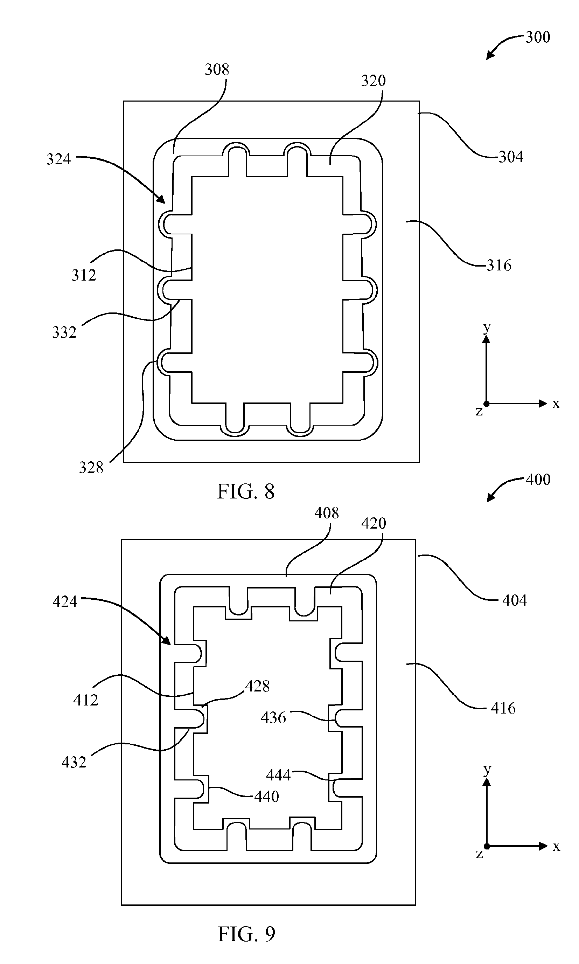

Another example which is not part of the invention of a MEMS 300 is shown in FIG. 8. The MEMS 300 includes a substrate 304, a wall 308, and a proof mass 312. The substrate 304 defines a surface 316 in the x-y plane that is generally normal, i.e. perpendicular, to the z-axis. The wall 308 is coupled to the substrate 304 and extends above the surface 316 along the z-axis. The wall 308 and the surface 316 define a cavity 320 having a length along the y-axis, a width along the x-axis, and a depth along the z-axis. The proof mass 312 is positioned in the cavity 320 to move relative the substrate 304 in response to the MEMS 300 accelerating in a direction having a component along the z-axis.

The MEMS 300 includes positioning features 324 to limit the movement of the proof mass 312 relative the substrate 304 in directions along the x-axis and the y-axis. The positioning features 324 include a follower 328 and a post 332. Some of the followers 328 are formed on the wall 308 and some of the followers 328 are formed on the proof mass 312. Similarly some of the posts 332 are formed on the wall 308 and some of the posts 332 are formed on the proof mass 312. The MEMS 300 has the same stiction threshold reducing benefits as described with reference to the MEMS 100.

With reference to FIG. 9, another embodiment of a MEMS 400 is illustrated. The MEMS 400 includes a substrate 404, a wall 408, and a proof mass 412. The substrate 404 defines a surface 416 in the x-y plane that is generally normal, i.e. perpendicular, to the z-axis. The wall 408 is coupled to the substrate 404 and extends above the surface 416 along the z-axis. The wall 408 and the surface 416 define a cavity 420 having a length along the y-axis, a width along the x-axis, and a depth along the z-axis. The proof mass 412 is positioned in the cavity 420 to move relative the substrate 404 in response to the MEMS 400 accelerating in a direction having a component along the z-axis.

The MEMS 400 includes positioning features 424 to limit the movement of the proof mass 412 relative the substrate 404 in directions along the x-axis and the y-axis. The positioning features 424 include a follower 428 and a travel stop 432. The travel stop 432 includes a head 436 having a curved surface. The followers 428 include a rectangular region 440 instead of a dimple 138. The positioning features 424 limit the over travel of the proof mass 412 in directions along both the x-axis and the y-axis. Additionally, the positioning features 424 reduce the contact area between the wall 408 and the proof mass 412 when the proof mass 412 has been moved to a position of maximum displacement. For instance, when the proof mass 412 has been moved to a position of maximum displacement along the x-axis, an apex 444 of the head 436 contacts a single point of the rectangular region 440. When the proof mass 412 has been moved to a position of maximum displacement along the x-axis and y-axis, however, the head 436 contacts the rectangular region 440 at discrete contact points. Thus the stiction threshold is reduced as compared to known flat positioning features.

The MEMS 100 may be formed according to the following process. First the substrate 108 is formed. In one embodiment, the substrate 108 is formed on a silicon wafer. Next, the surface 120 is etched, or otherwise micromachined, on the substrate 108. The term "etching" as used herein, includes wet chemical etching, vapor etching, and dry etching, among other forms of etching and micromachining. While the surface 120 is shown to be in the same x-y plane as the remainder of the substrate 108, the surface 120 may also be formed below the remainder of the substrate 108 in a well.

Next, material to form the spring 126 is deposited on the surface 120. A sacrificial layer of oxide may be formed on the surface 120 around the spring 126. Thereafter, material to form the wall 112 and the proof mass 116 is deposited on the surface 120, such that the material to form the proof mass 116 is deposited on the sacrificial layer and suspended above the surface 120. The material forming the proof mass 116 bonds to the spring 126. The material forming the wall 112 bonds to the surface 120. Next, a mask is deposited over the material. The mask the outlines and defines at least the wall 112, the proof mass 116, and the positioning features 132.

Subsequently, the material unencumbered by the mask is etched away to form the wall 112, the proof mass 116, and the positioning features 132. Additionally, the sacrificial layer, if one is present, is also etched away to separate the proof mass 116 from the surface 120 and to permit the spring 126 to support the proof mass 116 in the neutral position. The process may also include forming the retaining element 128 to seal the proof mass 116 within the cavity 124. Furthermore, a first electrical lead may be coupled to the surface 120, and a second electrical lead may be coupled to the proof mass 116. In some embodiments, the spring 126 may function as the second electrical lead.

In operation, the MEMS 100 senses acceleration in a direction having a component along the z-axis. In one embodiment, acceleration is sensed by measuring the capacitance between the surface 120 and the proof mass 116 with a capacitance measuring device coupled to first and second electrical leads. In particular, the proof mass 116 is shown in the neutral position slightly separated from the surface 120, resulting in a capacitance between the proof mass 116 and the surface 120. If the MEMS 100 were to accelerate downward along the z-axis, the proof mass 116 would move upward relative the surface 120. The capacitance measured between the proof mass 116 and the surface 120 decreases as the distance between the proof mass 116 and the surface 120 increases. The change in capacitance is related to the acceleration of the MEMS 100.

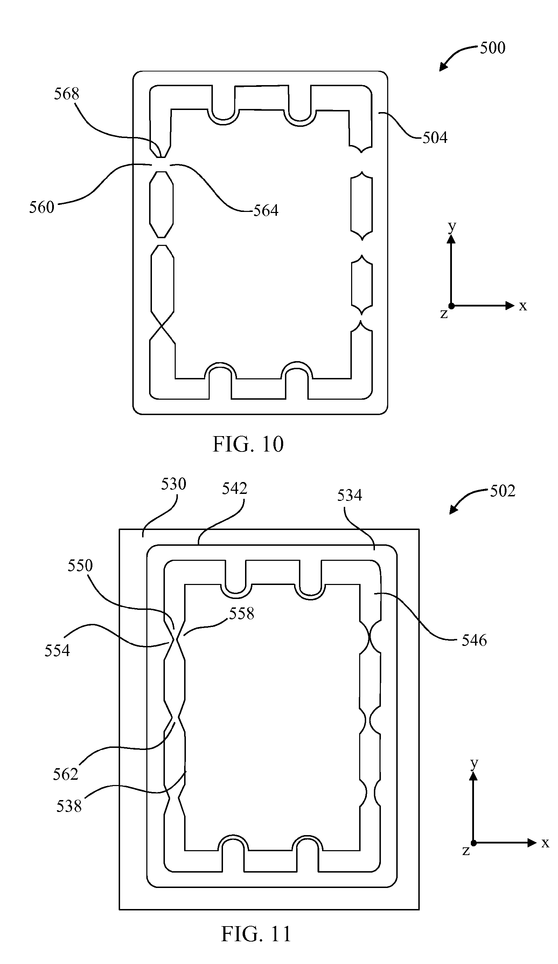

An exemplary mask 500 for forming a MEMS is illustrated in FIG. 10. The mask 500 is configured to form the MEMS 502 of FIG. 11. The MEMS 502 of FIG. 11 includes a substrate 530, a wall 534, and a proof mass 538. The substrate 530 defines a surface 542 in the x-y plane that is generally normal, i.e. perpendicular, to the z-axis. The wall 534 is coupled to the substrate 530 and extends above the surface 542 along the z-axis. The wall 534 and the surface 542 define a cavity 546 having a length along the y-axis, a width along the x-axis, and a depth along the z-axis. The proof mass 538 is positioned in the cavity 546 to move relative the substrate 530 in response to the MEMS 502 accelerating in a direction having a component along the z-axis. The MEMS 502 includes numerous positioning features 550 each having a wall element 554 and a proof mass element 558.

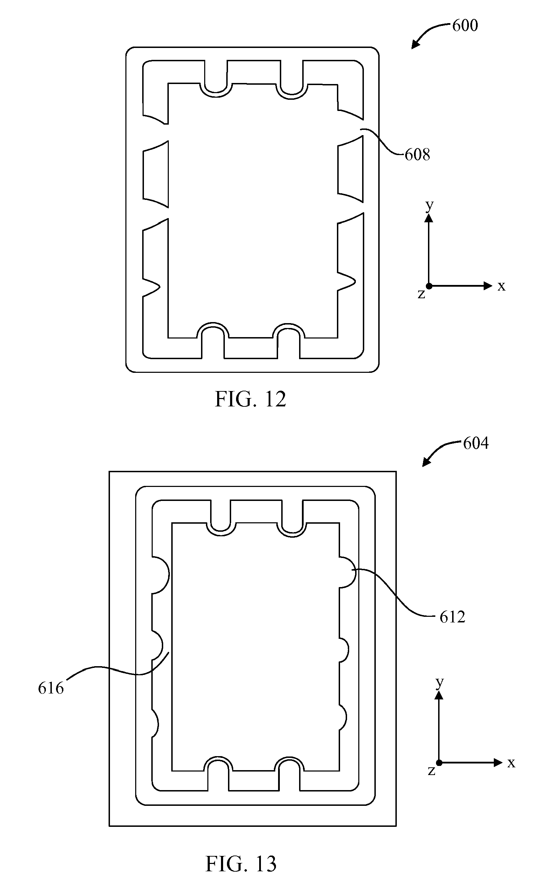

The mask 500 (FIG. 10) is used with a lateral silicon etch process to form submicron gaps 562 (FIG. 11) between the wall elements 554 and the proof mass elements 558. As shown in FIG. 10, the mask 500 is configured to form numerous types of positioning features 550. In particular, the mask 500 includes wall element mask portions 560 and proof mass element mask portions 564. The portions 560 and the portions 564 are bridged together at point 568 such that the portion 560 contacts the portion 564. During the lateral silicon etching process, however, some of the material extending under the portions 560, 564 and under the point 568 is etched, thereby forming and separating the wall element 554 from the proof mass element 558. The degree of lateral etching that occurs under the portions 560, 564 and under the point 568 is controlled by the area of the point 568, as shown by the submicron gaps 562 of FIG. 11. The submicron gaps 562 are arranged from smallest (top) to largest (bottom). The mask 600 of FIG. 12 is also configured to form a MEMS 604 (FIG. 13) using a lateral silicon etch process. The mask 600 includes positioning feature mask portions 608 that produce various widths of submicron gaps 616, as shown in the positioning features 612 in the MEMS 604 of FIG. 13. The submicron gaps 616 are arranged from smallest (top) to largest (bottom).

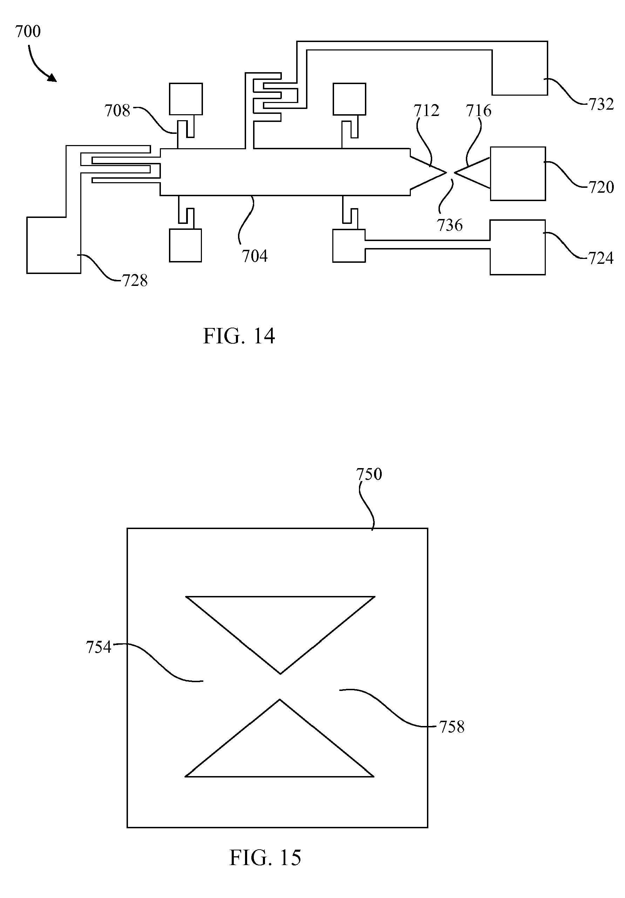

Lateral silicon etching may be used to form the MEMS tunneling tip accelerometer 700, shown in FIG. 14. Tunneling tip accelerometers are discussed in references including C. H. Liu and T. W. Kenny, "A High Precision, Wide Bandwidth Micromachined Tunneling Accelerometer", Journal of Microelectromechanical Systems, Vol. 10, No. 3, pp. 425-433 (2001); and P. G. Hartwell, F. M. Bertsch, K. L. Turner, and N. C. MacDonald, "Single Mask Lateral Tunneling Accelerometer", Microelectromechanical Systems Conference (1998). In the accelerometer 700 of FIG. 14, the proof mass 704 is supported by springs 708. The accelerometer 700 includes a first convex surface in the x-y plane, referred to as tip 712, and a second convex surface in the x-y plane, referred to as tip 716. A tunneling current flows from tip 712 to tip 716. The tunneling current is measured between pads 720 and 724. An electrostatic force feedback is applied to pads 728 and 732 to maintain a tunneling tip gap 736 and also to ensure stable tunneling current for a wide range of external acceleration input stimulus amplitudes. The field concentration of the accelerometer 700 is maximized at the tip location illustrated in FIG. 14. In some embodiments, a localized thermal oxidation may be applied to the tips 712, 716.

The tips 712, 716 of the accelerometer 700 may be formed by the following process. First, mask portion 750 of FIG. 15 is applied over a region of semiconductor material deposited on a substrate. The mask portion 750 includes tip masks 754, 758 that are bridged together. Next, a lateral etching process removes a portion of the semiconductor material extending under the mask portion 750. In particular, after the lateral etching process, the submicron gap 736 is formed between the tips 712, 716, even though the tip masks 754, 758 are bridged together.

### FURTHER. THE APPLICATION DESCRIBES THE FOLLOWING EMBODIMENTS:

Embodiment 8. An accelerometer for a micro electromechanical system (MEMS) comprising:
   a substrate;
   a proof mass at a position above a surface of the substrate and with a first curved surface located on a first side of the proof mass; and
   a travel stop with a second curved surface generally opposite to the first curved surface, wherein the first curved surface is movable in a direction toward the second curved surface.
Embodiment 9. The accelerometer of embodiment 8, wherein at least one of the first curved surface and the second curved surface is a generally convex surface in a plane generally parallel to the surface.
Embodiment 10. The accelerometer of embodiment 9, wherein the second curved surface is a generally convex surface in a plane generally parallel to the surface.
Embodiment 11. The accelerometer of embodiment 9, wherein the second curved surface is located in a protuberance.
Embodiment 12. The accelerometer of embodiment 9, wherein;
   the proof mass has a span along a first axis parallel to the surface of the substrate within which proof mass is allowed to move;
   the second curved surface is positioned generally opposite to the first curved surface along the first axis; and
   at least a portion of the first curved surface is positioned within a mouth of the second curved surface throughout the span.
Embodiment 13. The accelerometer of embodiment 8, further comprising:
   a second side of the proof mass with a third curved surface; and
   a second travel stop with a fourth curved surface generally opposite to the third curved surface, wherein the proof mass is movable along the second axis in a direction toward the fourth curved surface.
Embodiment 14. The accelerometer of embodiment 13, wherein the first side is adjacent to the second side.

## Claims

1. A micro electromechanical system (MEMS) comprising:
a substrate (108; 204, 404);
a proof mass (116; 212; 412) including a first follower (136; 428) with a first curved surface positioned above a surface (120; 216; 416) of the substrate (108; 204, 404) and movable in a plane parallel to the surface (120; 216; 416) of the substrate (108; 204, 404), the plane including an x-axis and a y-axis perpendicular to the x-axis;
a first travel stop (134; 432) including a first neck (147) and a first head (146; 436) defining a second curved surface generally opposite to the first curved surface along the x-axis, wherein the first curved surface, the first neck (147) and the first head (146; 436) are configured such that maximum displacement of the proof mass (116; 212; 412) solely along the y-axis results in a point contact between the first head (146; 436) and the first curved surface, and maximum displacement of the proof mass (116; 212; 412) solely along the x-axis results in a point contact between the first head (146; 436) and the first curved surface.

2. The MEMS of claim 1, wherein the first curved surface is a generally concave surface in the plane.

3. The MEMS of claim 2, wherein the second curved surface is a generally convex surface in the plane.

4. The MEMS of claim 2, wherein the second curved surface is located in a protuberance.

5. The MEMS of claim 4, wherein:
movement of the proof mass (116; 212; 412) along the x-axis is limited to a first distance;
the generally concave surface has a second distance from a mouth (140) of the generally concave surface to an apex (152) of the generally concave surface; and
the length of the first distance is less than the length of the second distance.

6. The MEMS of claim 1, wherein:
the proof mass (116; 212; 412) further includes a second follower (136; 428) with a third curved surface positioned above the surface (120; 216; 416) of the substrate (108; 204, 404); and
the MEMS further comprises a second travel stop (134; 432) including a second neck (147) and a second head (146; 436) defining a fourth curved surface generally opposite to the third curved surface along the y-axis.

7. The MEMS of claim 6, wherein:
the proof mass (116; 212; 412) further includes a third follower (136; 428) with a fifth curved surface positioned above the surface (120; 216; 416) of the substrate (108; 204, 404); and
the MEMS further comprises a third travel stop (134; 432) including a third neck (147) and a third head (146; 436) defining a sixth curved surface generally opposite to the fifth curved surface along the x-axis.

8. The MEMS of claim 6, wherein:
the first follower (136; 428) is on a first side of the proof mass (116; 212; 412); and
the second follower (136; 428) is on a second side of the proof mass (116; 212; 412), the second side being adjacent to the first side.

## Patentansprüche

1. Mikroelektromechanisches System (MEMS), das Folgendes umfasst:
ein Substrat (108; 204, 404);
eine Prüfmasse (116; 212; 412), die einen ersten Stößel (136; 428) mit einer ersten gekrümmten Fläche umfasst, die über einer Fläche (120; 216; 416) des Substrats (108; 204, 404) positioniert und in einer Ebene parallel zu der Fläche (120; 216; 416) des Substrats (108; 204, 404) beweglich ist, wobei die Ebene eine x-Achse und eine y-Achse senkrecht zu der x-Achse umfasst;
einen ersten Endanschlag (134; 432), der einen ersten Hals (147) und einen ersten Kopf (146; 436) umfasst, der eine zweite gekrümmte Fläche definiert, die der ersten gekrümmten Fläche allgemein entlang der x-Achse gegenüber liegt, wobei die erste gekrümmte Fläche, der erste Hals (147) und der erste Kopf (146; 436) so ausgebildet sind, dass ein maximaler Hub der Prüfmasse (116; 212; 412) allein entlang der y-Achse zu einem Punktkontakt zwischen dem ersten Kopf (146; 436) und der ersten gekrümmten Fläche führt und ein maximaler Hub der Prüfmasse (116; 212; 412) allein entlang der x-Achse zu einem Punktkontakt zwischen dem ersten Kopf (146; 436) und der ersten gekrümmten Fläche führt.

2. MEMS nach Anspruch 1, wobei die erste gekrümmte Fläche eine allgemein konkave Fläche in der Ebene ist.

3. MEMS nach Anspruch 2, wobei die zweite gekrümmte Fläche eine allgemein konvexe Fläche in der Ebene ist.

4. MEMS nach Anspruch 2, wobei die zweite gekrümmte Fläche in einem Vorsprung angeordnet ist.

5. MEMS nach Anspruch 4, wobei:
eine Bewegung der Prüfmasse (116; 212; 412) entlang der x-Achse auf eine erste Distanz begrenzt ist;
die allgemein konkave Fläche eine zweite Distanz von einer Mündung (140) der allgemein konkaven Fläche zu einem Scheitelpunkt (152) der allgemein konkave Fläche hat; und
die Länge der ersten Distanz geringer ist als die Länge der zweiten Distanz.

6. MEMS nach Anspruch 1, wobei:
die Prüfmasse (116; 212; 412) des Weiteren einen zweiten Stößel (136; 428) mit einer dritten gekrümmten Fläche umfasst, die über der Fläche (120; 216; 416) des Substrats (108; 204, 404) positioniert ist; und
das MEMS des Weiteren einen zweiten Endanschlag (134; 432) umfasst, der einen zweiten Hals (147) und einen zweiten Kopf (146; 436) umfasst, der eine vierte gekrümmte Fläche definiert, die der dritten gekrümmten Fläche allgemein entlang der y-Achse gegenüberliegt.

7. MEMS nach Anspruch 6, wobei:
die Prüfmasse (116; 212; 412) des Weiteren einen dritten Stößel (136; 428) mit einer fünften gekrümmten Fläche umfasst, die über der Fläche (120; 216; 416) des Substrats (108; 204, 404) positioniert ist; und
das MEMS des Weiteren einen dritten Endanschlag (134; 432) umfasst, der einen dritten Hals (147) und einen dritten Kopf (146; 436) umfasst, der eine sechste gekrümmte Fläche definiert, die der fünften gekrümmten Fläche allgemein entlang der x-Achse gegenüberliegt.

8. MEMS nach Anspruch 6, wobei:
der erste Stößel (136; 428) auf einer ersten Seite der Prüfmasse (116; 212; 412) angeordnet ist; und
der zweite Stößel (136; 428) auf einer zweiten Seite der Prüfmasse (116; 212; 412) angeordnet ist, wobei sich die zweite Seite neben der ersten Seite befindet.

## Revendications

1. Système micro-électromécanique (MEMS) comprenant:
un substrat (108 ; 204, 404) ;
une masse d'épreuve (116 ; 212 ; 412) comprenant un premier organe suiveur (136 ; 428) avec une première surface courbe positionnée au-dessus d'une surface (120 ; 216 ; 416) du substrat (108 ; 204, 404) et mobile dans un plan parallèle à la surface (120 ; 216 ; 416) du substrat (108 ; 204, 404), le plan comprenant un axe x et un axe y perpendiculaire à l'axe x ;
un premier limiteur de course (134 ; 432) comportant un premier col (147) et une première tête (146 ; 436) définissant une seconde surface courbe généralement opposée à la première surface courbe le long de l'axe x, dans lequel la première surface courbe, le premier col (147) et la première tête (146 ; 436) sont configurés de telle sorte que le déplacement maximal de la masse d'épreuve (116 ; 212 ; 412) uniquement le long de l'axe y résulte en un point de contact entre la première tête (146 ; 436) et la première surface courbe, et un déplacement maximal de la masse d'épreuve (116 ; 212 ; 412) uniquement le long de l'axe x résulte en un point de contact entre la première tête (146 ; 436) et la première surface courbe.

2. MEMS selon la revendication 1, dans lequel la première surface courbe est une surface généralement concave dans le plan.

3. MEMS selon la revendication 2, dans lequel la seconde surface courbe est une surface généralement convexe dans le plan.

4. MEMS selon la revendication 2, dans lequel la seconde surface courbe est située dans une protubérance.

5. MEMS selon la revendication 4, dans lequel :
le mouvement de la masse d'épreuve (116 ; 212 ; 412) le long de l'axe x est limité à une première distance ;
la surface généralement concave comporte une seconde distance allant d'une embouchure (140) de la surface généralement concave à un sommet (152) de la surface généralement concave ; et
la longueur de la première distance est inférieure à la longueur de la seconde distance.

6. MEMS selon la revendication 1, dans lequel :
la masse d'épreuve (116 ; 212 ; 412) comprend en outre un second organe suiveur (136 ; 428) avec une troisième surface courbe positionnée au-dessus de la surface (120 ; 216 ; 416) du substrat (108 ; 204, 404) ; et
le MEMS comprend en outre un second limiteur de course (134 ; 432) comprenant un second col (147) et une seconde tête (146 ; 436) définissant une quatrième surface courbe généralement opposée à la troisième courbe le long de l'axe y.

7. MEMS selon la revendication 6, dans lequel :
la masse d'épreuve (116 ; 212 ; 412) comprend en outre un troisième organe suiveur (136 ; 428) ayant une cinquième surface courbe positionnée au-dessus de la surface (120 ; 216 ; 416) du substrat (108 ; 204, 404) ; et
le MEMS comprend en outre un troisième limiteur de course (134 ; 432) comprenant un troisième col (147) et une troisième tête (146 ; 436) définissant une sixième surface courbe généralement opposée à la cinquième surface courbe le long de l'axe x.

8. MEMS selon la revendication 6, dans lequel :
le premier organe suiveur (136 ; 428) est sur un premier côté de la masse d'épreuve (116 ; 212 ; 412) ; et
le second organe suiveur (136 ; 428) est sur un second côté de la masse d'épreuve (116 ; 212 ; 412), le second côté étant adjacent au premier côté.
